# EUROPÄISCHE PATENTSCHRIFT

(11) **EP 2 470 683 B1**
(45) Veröffentlichungstag und Bekanntmachung des Hinweises auf die Patenterteilung: **04.09.2019**
(21) Anmeldenummer: 10757031.9
(22) Anmeldetag: 09.09.2010
(51) Int. Cl.: C23C 14/02, C23C 14/06, C23C 14/08, C23C 14/16, C23C 14/58, G02B 1/02, G02B 1/10, G02B 5/08

(54) **SUBSTRAT AUS EINER ALUMINIUM-SILIZIUM-LEGIERUNG ODER KRISTALLINEM SILIZIUM, METALLSPIEGEL, VERFAHREN ZU DESSEN HERSTELLUNG SOWIE DESSEN VERWENDUNG**
SUBSTRATE MADE OF AN ALUMINUM-SILICON ALLOY OR CRYSTALLINE SILICON, METAL MIRROR, METHOD FOR THE PRODUCTION THEREOF, AND USE THEREOF
SUBSTRAT CONSTITUÉ D'UN ALLIAGE ALUMINIUM-SILICIUM OU DE SILICIUM CRISTALLIN, MIROIR MÉTALLIQUE, PROCÉDÉ DE FABRICATION ET UTILISATION DUDIT MIROIR MÉTALLIQUE

(30) Priorität: 09.09.2009 DE 102009040785
(43) Veröffentlichungstag der Anmeldung: 04.07.2012
(73) Patentinhaber: Fraunhofer-Gesellschaft zur Förderung der angewandten Forschung e.V., 80686 München (DE)
(72) Erfinder: RISSE, Stefan, 07749 Jena (DE); GEBHARDT, Andreas, 99510 Apolda (DE); PESCHEL, Thomas, 07743 Jena (DE); STÖCKL, Wieland, 07749 Jena (DE)
(74) Vertreter: Pfenning, Meinig & Partner mbB
(86) Internationale Anmeldenummer: PCT/EP2010/005556
(87) Internationale Veröffentlichungsnummer: WO 2011/029603

(56) Entgegenhaltungen:
- CH-A5- 600 354
- DE-A1- 19 830 449
- DE-A1-102005 026 418
- JP-A- 5 228 677
- US-A- 4 495 218
- US-A1- 2005 106 320
- US-A1- 2007 020 923
- US-A1- 2008 118 662
- LI ET AL: "Corrosion protection properties of anodic oxide coatings on an Al-Si alloy", SURFACE AND COATINGS TECHNOLOGY, ELSEVIER, AMSTERDAM, NL, Bd. 200, Nr. 5-6, 21. November 2005 (2005-11-21), Seiten 1994-2000, XP005173255, ISSN: 0257-8972, DOI: DOI:10.1016/J.SURFCOAT.2005.08.019
- DATABASE INSPEC [Online] THE INSTITUTION OF ELECTRICAL ENGINEERS, STEVENAGE, GB; Dezember 1993 (1993-12), MESRATI N ET AL: "Role of zinc and silver in the adhesion of plasma sprayed zirconia on aluminium-12% silicon alloys", XP002617860, Database accession no. 4653758 & REVUE DE METALLURGIE FRANCE, Bd. 90, Nr. 12, Dezember 1993 (1993-12), Seiten 1673-1680, ISSN: 0035-1563

## Beschreibung

Die Erfindung betrifft ein beschichtetes Substrat, umfassend ein Substrat aus einer Aluminium-Silizium-Legierung oder kristallinem Silizium mit aufgebrachter polierbarer Schicht sowie einen Metallspiegel, der dieses Substrat umfasst. Weiterhin betrifft die Erfindung ein Verfahren zur Herstellung von Metallspiegeln wie auch die Verwendung des erfindungsgemäßen Metallspiegels.

Gegenwärtig wächst der Bedarf zur ultrapräzisen Herstellung von komplexen Optikflächen (Freiformen, Asphären) mit hohen Anforderungen an die Bauteiloberflächen (Form und Rauheit) und an den zulässigen Temperaturbereich. Dabei sind potentielle Anwendungen in den Bereichen Lasertechnik, Wehrtechnik, Weltraum und Lithographie angesiedelt.

Die Ultrapräzisionsbearbeitung (Diamantdrehen und -fräsen) bietet die Möglichkeit, Metalloptiken mit komplexen Oberflächenformen herzustellen. Stand der Technik ist die Drehbearbeitung sphärischer und asphärischer Flächen mit Formabweichungen < 200 nm bei einem Bauteildurchmesser von 100 mm und Rauheiten von RMS = 2...5 nm für geeignete Werkstoffe wie Aluminium, Kupfer oder Nickel. Während damit die Anforderungen für IR-Anwendungen hinsichtlich der Formabweichung erfüllt werden, ist die durch diesen Zerspanungsprozess erreichbare Rauhigkeit und Formtreue für kurze Wellenlängen unzureichend. Damit wird eine anschließende Feinpolitur beziehungsweise Korrekturpolitur notwendig. Dieser Prozess wird vorzugsweise mit Aluminiumsubstraten, die mit einer amorphen Nickel-Phosphor-Schicht (NiP) versehen sind, durchgeführt. Nachteil dieser Materialpaarung ist der erhebliche Unterschied der thermischen Ausdehnung von Aluminium (23,8 ppm/K) und einer NiP-Schicht (12 ppm/K). Unterliegen die Optikteile im Einsatz einem Temperaturwechsel, entstehen durch den resultierenden Bimetalleffekt Spannungen und Deformationen, die die optische Wirkung erheblich beeinflussen können beziehungsweise in vielen Fällen die beschriebene Technologie unmöglich machen.

Durch die Verwendung einer ausdehnungsangepassten Legierung (AlSi₄₀, AlSi₄₂) mit nahezu gleichen Ausdehnungskoeffizienten (12,5 ppm/K bzw. 12,8 ppm/K) wie NiP kann dieser Nachteil beseitigt werden. Ein weiterer Vorteil der Materialpaarung liegt in der geringeren Dichte und dem höheren E-Moduls der Al-Si-Legierung, was sowohl Leichtgewichtsanwendungen, als auch einer verbesserter Formgenauigkeit entgegenkommt (DE 102 005 026 418). Im Falle der Finishbearbeitung in einer NiP-Schicht ist eine erneute Bearbeitung durch Diamantdrehen in der Dickschicht notwendig und möglich. Neben dem erhöhten Fertigungsaufwand ist damit eine Mindestdicke der Schicht unvermeidlich. Generell ist die Formkorrektur der Optikfläche durch Diamantdrehen in weichen Metallen wie Aluminium 6061 oder andere Aluminiumlegierungen zielführender als in harten Chemisch-Nickel-Schichten. Ein Nachteil von chemischen NiP als Polierschicht besteht in der Unbeständigkeit der amorphen Struktur bei erhöhten Temperaturen. Die thermisch induzierte beginnende Rekristallisation der NiP-Legierung bei Temperaturen oberhalb von 220 °C führt zum dramatischen Aufrauen der Oberfläche (Orangenhaut-Effekt) und Aufbau mechanischer Spannungen, die einen Einsatz im Hochtemperaturbereich nicht gestatten.

Neben Metallsubstraten für High-End-Spiegel existieren Lösungsansätze, die auf dem Einsatz von Siliziumcarbid als Spiegelträger beruhen. Zweifelsohne hat dieses keramisches Material hervorragende mechanische Eigenschaften und es können hochqualitative Optikflächen realisiert werden, jedoch ist der technologische Aufwand zur Herstellung der Spiegelformen, insbesondere aber auch die gerätetechnische Umsetzung von Gehäuse, Fassungen und Gesamtinstrument immens aufwendig. Eine flexible CNC-Bearbeitung ist nicht möglich.

Im Vergleich zum oben genannten AlSiₓₓ/NiP-System ist aufgrund des größeren Verhältnisses von Wärmeleitfähigkeit zu thermischer Ausdehnung andererseits die Stabilität gegen thermische Gradienten, insbesondere durch absorbierte Strahlung ("thermische Linse"), deutlich besser. Weitere aus dem Stand der Technik bekannte beschichtete Substrate sind in den Druckschriften "LI ET AL: "Corrosion protection properties of anodic oxide coatings on an Al-Si alloy",SURFACE AND COATINGS TECHNOLOGY, ELSEVIER, AMSTERDAM, NL, Bd. 200, Nr. 5-6, 21. November 2005 (2005-11-21), Seiten 1994-2000, XP005173255", "MESRATI N ET AL: "Role of zinc and silver in the adhesion of plasma sprayed zirconia on aluminium-12% silicon alloys", ; & REVUE DE METALLURGIE FRANCE,Bd. 90, Nr. 12, Dezember 1993 (1993-12), Seiten 1673-1680", JP 5 228677 A, CH 600 354 A5, US 4 495 218 A, US 2008/118662 A1, US 2005/106320 A1, US 2007/020923 A1 und DE 198 30 449 A1 beschrieben.

Ausgehend hiervon ist es Aufgabe der vorliegenden Erfindung eine beständige, polierbare beziehungsweise polierte Schicht auf einem Substrat mit geringerem gerätetechnischem Aufwand herzustellen, wobei die eingesetzten Materialien vergleichbare Ausdehnungskoeffizienten aufweisen.

Diese Aufgabe wird durch das beschichtete Substrat mit den Merkmalen des Anspruchs 1 gelöst. Anspruch 5 betrifft einen Metallspiegel, Anspruch 11 ein Verfahren zur Herstellung des Metallspiegels und Anspruch 13 dessen Verwendung. Weitere vorteilhafte Ausführungsformen sind in den abhängigen Ansprüchen enthalten.

Erfindungsgemäß besteht das Substrat aus einer Aluminium-Silizium-Legierung oder kristallinem Silizium mit aufgebrachter polierbarer Schicht, die aus amorphem Silizium, mikrokristallinem Silizium, Siliziumcarbid, Siliziumnitrid, Titannitrid, Aluminiumoxid, Zirconiumdioxid, Chrom und/oder Mischungen hiervon besteht, wobei eine Zwischenschicht zwischen dem Substrat und der polierbaren Schicht angeordnet ist, die als Haftvermittler- oder als Barriere-Schicht wirkt und die Zwischenschicht aus Aluminiumoxid, Zirkoniumoxid, Titan oder Chrom besteht.

Die AlSiₓₓ-Legierung kann dabei modifiziert werden (z.B. 42 % Si; 50 % Si; 60 % Si). Mit der stöchiometrischen Zusammensetzung werden bestimmte Eigenschaften erreicht beziehungsweise gezielt verändert (E-Modul; Masse; Ausdehnungskoeffizient).

Die Idee der Erfindung ist es, das Substrat aus einer Aluminium-Silizium-Legierung durch ultrapräzise Diamantbearbeitung herzustellen, dieses mit einer polierfähigen Silizium-Schicht zu versehen und durch Polierverfahren (CMP: chemisch mechanisches Polieren, IBF: Ionbeamfinishing bzw. Ionenstrahlpolieren) die Qualität der spiegelnden Oberfläche durch die Bearbeitung der Silizium-Schicht zu erzeugen. Final kann eine Vergütung mit einer optischen Funktionsschicht (Reflexionsschicht) erfolgen.

Das Substrat (bzw. Spiegel-Bulk-Material) besteht aus einer spanend bearbeitbaren Aluminium-Silizium-Legierung. Damit ist eine CNC Fräs/Bohr/Drehbearbeitung mit hoher Flexibilität möglich. Die Fläche, die letztlich als optisch wirkende Fläche dient, wird durch Diamantbearbeitung erzeugt.

Es ist erfindungsgemäß eine Zwischenschicht zwischen dem Substrat und der polierbaren Schicht angeordnet sein, die als Haftungsvermittler- oder als Barriere-Schicht wirkt. Eine Voraussetzung für die Beschichtung ist eine entsprechend gute Reinigung der zu beschichtenden Oberfläche, z.B. der SubstratOberfläche. Somit ist es möglich sowohl eine gute Schichthaftung als auch Schichtqualität zu erhalten.

Die polierbare Schicht kann dabei eine Dicke von 1 µm bis 10 pm, bevorzugt von 3 µm bis 6 µm aufweisen. Die Dicke der Zwischenschicht, die gegebenenfalls mehreren Schichten beinhaltet, liegt vorzugsweise zwischen 20 und 200 nm, bevorzugt 100 nm.

Die Zwischenschicht besteht aus Aluminiumoxid, Zirkoniumoxid, Titan oder Chrom. Diese Materialien können auch eine gute Anpassung z.B. der Ausdehnungskoeffizienten der verschiedenen Materialien bewirken, was weiterhin zur Erhöhung der Langzeitstabilität des beschichteten Substrats beiträgt.

In einer weiteren Variante des erfindungsgemäßen Substrats beträgt der Silizium-Gehalt der Aluminium-Silizium-Legierung zwischen 25 und 90 Gew.%, bevorzugt zwischen 40 und 80 Gew.%, bezogen auf die Gesamtmasse der Aluminium-Silizium-Legierung.

Pulvermetallurgisch sind derzeit Aluminium-Silizium-Legierungen mit Silizium-Anteilen bis zu 87 % möglich. Damit ist eine weitgehende CTE-Anpassung, also Anpassung des Ausdehnungskoeffizienten, von Substrat und polierbarer Schicht erreichbar. Gleichzeitig ist mit steigendem Silizium-Gehalt eine signifikante Erhöhung der Wärmeleitfähigkeit, der spezifischen Steifigkeit und der Temperaturstabilität (Verhältnis Leitfähigkeit zu Ausdehnung) verbunden.

Erfindungsgemäß umfasst der Metallspiegel ein Substrat wie bereits beschrieben, wobei die polierbare Schicht in optischer Qualität poliert ist.

Nach der Beschichtung des Substrats mit z.B. Silizium erfolgt ein Glätten der Oberflächenstrukturen. Silizium stellt ein wohlbekanntes Material hinsichtlich seiner Poliereigenschaften dar. Umfangreiche Erkenntnisse liegen aus dem Gebiet der Waferpolitur aber auch aus der Herstellung von Infrarotoptiken und Spiegeln vor. Für Anwendungen im extrem kurzwelligen Spektralbereich (EUV-Kollektorspiegel) sind Superpolituren von Silizium von wenigen Angström RMS bekannt. Geeignete Glättverfahren sind beispielsweise klassische, chemisch-mechanische Polierverfahren sowie magneto-rheologische Poliertechniken. Für Formkorrekturen können ebenfalls CMP (chemisch-mechanisches Polieren), MRF (magneto-rheologisches Finishing) aber auch Ionenstrahlverfahren eingesetzt werden. Die gute Homogenität und Reinheit der Schicht führt zu einer konstanten Abtragsfunktion und damit zu einer konvergierenden Formkorrektur.

Weiterhin kann der Metallspiegel auf der vom Substrat abgewandten Oberfläche der polierten Schicht mindestens eine Vergütungsschicht aufweisen. Bevorzugt ist mindestens eine Vergütungsschicht eine metallische Schicht, insbesondere ausgewählt aus der Gruppe bestehend aus Gold, Aluminium, Silber, Silizium-Molybdän und Mischungen hiervon. Mindestens eine Vergütungsschicht kann eine dielektrische Schicht oder eine metall-dielektrische Schicht sein.

Die Vergütungsschicht kann, je nach Wellenlängenbereich, aus verschiedenen Materialien bestehen. Eine typische Schicht für den infraroten Spektralbereich ist Gold. Aluminium und Silber oder dielektrische Schichtstapel können für den sichtbaren Spektralbereich eingesetzt werden. Insbesondere für extrem kurze Wellenlängen (13 nm) stellt Silizium das Substrat für Si/Mo-Schichtstacks dar, die in diesem Spektralbereich die einzige Alternative für Reflektionen > 68 % darstellen. EUV steht für Wellenlängen im extrem-ultraviolett Bereich, also 13 bis 13,5 nm. Durch einen Mehrschichtaufbau aus Silizium-Molybdän-Silizium-Molybdän in alternierender Abfolge kann bei mehr als 50 und weniger als 200 Doppelschichten die Reflexion auf ca. 68 % angehoben werden. Als Anwendungen hierfür können beispielsweise Spiegel bzw. Kollektorspiegel im Bereich der Quelle genannt werden.

Weiterhin kann der Metallspiegel auf der Vergütungsschicht eine weitere Schicht, insbesondere eine Schutzschicht, angeordnet sein. Diese weist eine besonders gute Kratzbeständigkeit auf und stellt einen Schutz vor Umwelteinflüssen, z.B. Oxidation oder Feuchtigkeit, dar.

Typische Vergütungsschichten wie Gold für den IR-Bereich oder Silber für multispektrale Anwendungen können mit einer Schutzschicht versehen sein. Weiterhin sind auch Haftvermittlungsschichten oder Diffusionsbarriereschichten möglich.

Die Materialien für die Schutzschicht ausgewählt sind bevorzugt ausgewählt aus der Gruppe der Metalloxide.

Erfindungsgemäß ist auch ein Verfahren zur Herstellung von Metallspiegeln umfasst, wobei die Zwischenschicht, die polierte Schicht, die Vergütungsschicht und/oder die Schutzschicht mittels chemischer Gasphasenabscheidung, Atomlagenabscheidung, Elektronenstrahlverdampfung und/oder Sputterprozessen aufgebracht sind. Weiterhin kann auch Magnetronsputtern eingesetzt werden.

Aluminium-Silizium-Legierungen, die erfindungsgemäß als Substrat eingesetzt werden, können mit herkömmlichen Hartmetallwerkzeugen, PKD-Werkzeugen und mit präzisen Diamantwerkzeugen bearbeitet werden. Bei zunehmendem Silizium-Anteil werden die Werkstoffe spröder, der Einfluss des Siliziums nimmt zu. Gute Bearbeitungsergebnisse werden erzielt, wenn im Vergleich zur Bearbeitung von Aluminium-Legierungen geringere Schnitttiefen und geringere Vorschübe verwendet werden. Unter Beachtung der vom Materialhersteller gegebenen Bearbeitungshinweise bestehen prinzipiell keine wesentlichen Einschränkungen der herstellbaren Formen. Lediglich eine Mindestwandstärke (ca. 0,6 mm) sollte beachtet werden.

Nach der konventionellen Bearbeitung (Vorfertigung) mit einem Aufmaß von typischerweise einem Millimeter erfolgt das Tempern des Materials, um eingebrachte Spannungen zu reduzieren. Gute Erfahrungen konnten mit Behandlungen bei 350 °C bei einer Dauer von 6 Stunden gemacht werden. Anschließend erfolgt eine Bearbeitung ebenfalls mit konventioneller Maschinentechnik. Die anschließende mechanische Bearbeitung erfolgt mit einer Formgenauigkeit < 1 µm P-V (peak to valley) sowie Rauheitswerten von ca. 5 nm bis 40 nm RMS (root mean square) durch eine Diamantbearbeitung. Die entstehenden Flächen zeigen mikroskopisch die Gefügestruktur (Al- und Si-Kristallite). Die Bearbeitungsparameter sind mit denen bei der Bearbeitung herkömmlicher Aluminium-Legierungen (Al6061, AlSi0.5) identisch. Die Bearbeitung von ausgedehnten Spiegelflächen > (100 mm)² ist ohne Probleme innerhalb der Werkzeugstandzeit möglich. Die Möglichkeit der Bearbeitung des Substrat-Materials mit bestimmter Schneide ist ein wesentlicher Vorteil gegenüber harten, sprödelastischen Materialien wie z.B. Siliziumcarbid.

Während der Abscheidung der polierbaren Schicht kann die Beschichtungstemperatur auf bis zu 150 °C ansteigen. Diese Schichtabscheidung erfolgt üblicherweise in einem Druckbereich von 8·10⁻⁴ mbar bis 5·10⁻³ mbar.

Das Sputtergas ist dabei vorzugsweise ausgewählt aus der Gruppe bestehend aus Argon, Sauerstoff, Xenon und Mischungen hiervon. Wenn Oxide abgeschieden werden, wird vorzugsweise Argon und Sauerstoff als Sputtergas eingesetzt. Entscheidend für die Qualität der abgeschiedenen Schichten ist der Basisdruck, der unterhalb von 5·10⁻⁷ mbar liegen sollte.

Wenn Haft- bzw. Barriereschichten abgeschieden werden, die eine Schichtdicke unterhalb von 100 nm besitzen, steigt die Beschichtungstemperatur nicht über 40 °C an. Durch die Haft- bzw. Barriereschichten kann beispielsweise auch Interdiffusion vermieden werden.

Sofern die polierbare Schicht durch Magnetronsputtern aufgebracht ist, entstehen durch das hochenergetische Beschichtungsverfahren eine hohe Schichthaftung, geringe Spannungen und eine porenfreie und homogene Schicht. Verfahrensbedingt wächst die Schicht amorph oder mikrokristallin auf. Dies ist eine günstige Voraussetzung für das Erreichen geringer Rauheiten < 2 nm RMS durch die Schichtpolitur.

Ein weiterer Vorteil der Herstellung der polierbaren Schicht durch Sputtern besteht in der hohen Reinheit der Schicht. Typischerweise wird als Target hochreines Silizium (99,XX %) verwendet. Die Dicke der abgeschiedenen Schicht wird üblicherweise so eingestellt, dass die typische Oberflächenstruktur des Diamantdrehens (Drehrillen) sowie Oberflächendefekte sicher auspoliert werden können.

In einer Variante des Verfahrens zur Herstellung von Metallspiegeln können der Silizium-Gehalt der Aluminium-Silizium-Legierung sowie die Dicke und die Materialien der polierten Schicht so gewählt sein, dass Deformationen durch Temperaturwechsel weitgehend vermieden werden. Somit ist ein sehr stabiler, präziser Metallspiegel erzeugbar.

Erfindungsgemäß ist auch die Verwendung des Metallspiegels in einem Spiegelteleskop (TMA: Three-Mirror-Anastigmat Telescope, RC: Ritchey-Chretien-Teleskop u.a.) oder in einer EUV-Strahlquelle als Kollektorspiegel umfasst.

Die folgende Figur und das folgende Beispiel sollen den erfindungsgemäßen Gegenstand näher beschreiben, ohne die Erfindung auf diese Variante einzuschränken.

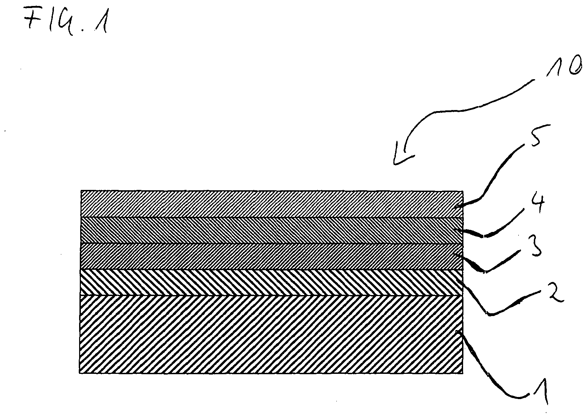

- Fig. 1: zeigt einen möglichen Schichtaufbau des erfindungsgemäßen Metallspiegels.

In Figur 1 ist eine Ausführungsform des erfindungsgemäßen Metallspiegels 10 dargestellt. Auf dem Substrat 1 aus AlSiₓₓ-Bulkmaterial ist eine Zwischenschicht 2 abgeschieden, die als Haftungsvermittler- oder Barriere-Schicht dient. Auf dieser Zwischenschicht 2 ist eine polierte Schicht 3 angeordnet. Zusätzlich weist der erfindungsgemäße Metallspiegel 10 noch eine Vergütungsschicht 4 auf, die zwischen der Schutzschicht 5 und der polierten Schicht 3 liegt.

### Beispiel

Eine Silizium-Schicht wird mittels Magnetronsputtern, ausgehend von einem kristallinen Silizium-Target abgeschieden. Dazu sind je nach Art des zu beschichtenden Spiegelträgers (bzw. Substrats) Haftungsvermittler-Schichten oder Barriere-Schichten notwendig, um so eine bessere Haftung zu erzielen bzw. Interdiffusion zu vermeiden. Auch diese Schichten werden mittels Magnetronsputtern (reaktiv) aufgebracht. Dabei können sowohl Metalloxide als auch Metalle zum Einsatz kommen. Die Beschichtungstemperatur ist von den abzuscheidenden Schichtdicken abhängig. Die Haftungsvermittler-Schichten oder Barriere-Schichten weisen eine Schichtdicke unterhalb von 100 nm auf, weshalb die Beschichtungstemperatur nicht über 40 °C ansteigt. Während der Abscheidung der polierbaren Silizium-Schicht (> 3 pm) kann die Beschichtungstemperatur auf bis zu 150 °C ansteigen. Die Schichtabscheidung wird in einem Druckbereich von 8·10⁻⁴ mbar bis 5·10⁻³ mbar durchgeführt. Als Sputtergas wird Argon verwendet. Wenn Oxide abgeschieden werden, wird eine Mischung aus Argon und Sauerstoff als Sputtergas eingesetzt. Entscheidend für diese Schichten ist der Basisdruck, der unterhalb von 5·10⁻⁷ mbar liegen sollte.

## Patentansprüche

1. Beschichtetes Substrat, umfassend ein Substrat (1) aus einer Aluminium-Silizium-Legierung oder kristallinem Silizium mit aufgebrachter polierbarer Schicht (3), die aus amorphem Silizium, mikrokristallinem Silizium, Siliziumcarbid, Siliziumnitrid, Titannitrid, Aluminiumoxid, Zirconiumdioxid, Chrom und/oder Mischungen hiervon besteht, wobei eine Zwischenschicht (2) zwischen dem Substrat (1) und der polierbaren Schicht (3) angeordnet ist, die als Haftungsvermittler- oder als Barriere-Schicht wirkt und die Zwischenschicht (2) aus Aluminiumoxid, Zirkoniumoxid, Titan oder Chrom besteht.

2. Beschichtetes Substrat gemäß einem der vorhergehenden Ansprüche, **dadurch gekennzeichnet, dass** die polierbare Schicht (3) eine Dicke von 1 µm bis 10 µm, bevorzugt von 3 µm bis 6 µm aufweist.

3. Beschichtetes Substrat gemäß Anspruch 2, **dadurch gekennzeichnet, dass** die Dicke der Zwischenschicht (2), die gegebenenfalls mehrere Schichten beinhaltet, zwischen 20 und 200 nm liegt.

4. Beschichtetes Substrat gemäß einem der vorhergehenden Ansprüche, **dadurch gekennzeichnet, dass** der Silizium-Gehalt der Aluminium-Silizium-Legierung zwischen 25 und 90 Gew.%, bevorzugt zwischen 40 und 80 Gew.%, bezogen auf die Gesamtmasse der Aluminium-Silizium-Legierung, beträgt.

5. Metallspiegel (10) umfassend ein beschichtetes Substrat gemäß einem der vorhergehenden Ansprüche, wobei die polierbare Schicht (3) in optischer Qualität poliert ist.

6. Metallspiegel (10) gemäß dem vorhergehenden Anspruch, **dadurch gekennzeichnet, dass** auf der vom Substrat (1) abgewandten Oberfläche der polierten Schicht (3) mindestens eine Vergütungsschicht (4) angeordnet ist.

7. Metallspiegel (10) gemäß dem vorhergehenden Anspruch, **dadurch gekennzeichnet, dass** mindestens eine Vergütungsschicht (4) eine metallische Schicht, insbesondere ausgewählt aus der Gruppe bestehend aus Gold, Aluminium, Silber, Silizium-Molybdän und Mischungen hiervon, ist.

8. Metallspiegel gemäß einem der Ansprüche 6 oder 7, **dadurch gekennzeichnet, dass** mindestens eine Vergütungsschicht eine dielektrische Schicht oder eine metall-dielektrische Schicht ist.

9. Metallspiegel (10) gemäß einem der Ansprüche 6 bis 8, **dadurch gekennzeichnet, dass** auf der Vergütungsschicht (4) eine weitere Schicht, insbesondere eine Schutzschicht (5), angeordnet ist.

10. Metallspiegel (10) gemäß dem vorhergehenden Anspruch, **dadurch gekennzeichnet, dass** die Materialien für die Schutzschicht (5) ausgewählt sind aus der Gruppe der Metalloxide.

11. Verfahren zur Herstellung von Metallspiegeln (10) nach einem der Ansprüche 5 bis 10 bei dem die Zwischenschicht (2), die polierte Schicht (3), die Vergütungsschicht (4) und/oder die Schutzschicht (5) mittels chemischer Gasphasenabscheidung, Atomlagenabscheidung, Elektronenstrahlverdampfung und/oder Sputterprozessen aufgebracht werden.

12. Verfahren zur Herstellung von Metallspiegeln (10) gemäß dem vorhergehenden Anspruch, **dadurch gekennzeichnet, dass** das Sputtergas ausgewählt ist aus der Gruppe bestehend aus Argon, Sauerstoff, Xenon und Mischungen hiervon.

13. Verwendung des Metallspiegels (10) gemäß einem der Ansprüche 5 bis 10 und/oder hergestellt gemäß einem der Ansprüche 11 bis 12 in einem Spiegelteleskop oder in einer EUV-Strahlquelle als Kollektorspiegel.

## Claims

1. Coated substrate comprising a substrate (1) made of an aluminium-silicon alloy or crystalline silicon to which a polishable layer (3) is applied, which layer consists of amorphous silicon, microcrystalline silicon, silicon carbide, silicon nitride, titanium nitride, aluminium oxide, zirconium oxide, chromium and/or mixtures hereof, wherein
an intermediate layer (2) which acts as adhesive- or as barrier layer is disposed between the substrate (1) and the polishable layer (3), and the intermediate layer (2) consists of aluminium oxide, zirconium oxide, titanium or chromium.

2. Coated substrate (1) according to one of the preceding claims,
**characterised in that** the polishable layer (3) has a thickness of 1 µm to 10 µm, preferably of 3 µm to 6 µm.

3. Coated substrate (1) according to claim 2,
**characterised in that** the thickness of the intermediate layer (2) which comprises possibly a plurality of layers is between 20 and 200 nm.

4. Coated substrate (1) according to one of the preceding claims,
**characterised in that** the silicon content of the aluminium-silicon alloy is between 25 and 90% by weight, preferably between 40 and 80% by weight, relative to the total mass of the aluminium-silicon alloy.

5. Metal mirror (10) comprising a substrate (1) according to one of the preceding claims, the polishable layer (3) being polished to optical quality.

6. Metal mirror (10) according to the preceding claim,
**characterised in that** at least one coating layer (4) is disposed on the surface of the polished layer (3) orientated away from the substrate (1).

7. Metal mirror (10) according to the preceding claim,
**characterised in that** at least one coating layer (4) is a metallic layer, in particular selected from the group consisting of gold, aluminium, silver, silicon-molybdenum and mixtures hereof.

8. Metal mirror according to one of the claims 6 or 7,
**characterised in that** at least one coating layer is a dielectric layer or a metal-dielectric layer.

9. Metal mirror (10) according to one of the claims 8 to 10,
**characterised in that** a further layer, in particular a protective layer (5), is disposed on the coating layer (4).

10. Metal mirror (10) according to the preceding claim,
**characterised in that** the materials for the protective layer (5) are selected from the group of metal oxides.

11. Method for the production of metal mirrors (10) according to one of claims 5 to 10, in which
the intermediate layer (2), the polished layer (3), the coating layer (4) and/or the protective layer (5) are applied by means of chemical vapour deposition, atomic layer deposition, electron beam evaporation and/or sputtering processes.

12. Method for the production of metal mirrors (10) according to the preceding claim,
**characterised in that** the sputtering gas is selected from the group consisting of argon, oxygen, xenon and mixtures hereof.

13. Use of the metal mirror (10) according to one of the claims 5 to 10 and/or produced according to one of the claims 11 to 12 in a reflecting telescope or in an EUV beam source as collector mirror.

## Revendications

1. Substrat revêtu, comprenant un substrat (1) en alliage d'aluminium-silicium ou en silicium cristallin sur lequel est appliquée une couche (3) polissable qui se compose de silicium amorphe, de silicium microcristallin, de carbure de silicium, de nitrure de silicium, de nitrure de titane, d'oxyde d'aluminium, de dioxyde de zirconium, de chrome et/ou de mélanges de ceux-ci, une couche intermédiaire (2) étant disposée entre le substrat (1) et la couche (3) polissable et agissant en tant que couche promotrice d'adhérence ou en tant que couche barrière, et la couche intermédiaire (2) se composant d'oxyde d'aluminium, d'oxyde de zirconium, de titane ou de chrome.

2. Substrat revêtu selon l'une des revendications précédentes, **caractérisé en ce que** la couche (3) polissable présente une épaisseur de 1 µm à 10 µm, de préférence de 3 µm à 6 µm.

3. Substrat revêtu selon la revendication 2, **caractérisé en ce que** l'épaisseur de la couche intermédiaire (2), qui contient éventuellement plusieurs couches, est comprise entre 20 et 200 nm.

4. Substrat revêtu selon l'une des revendications précédentes, **caractérisé en ce que** la teneur en silicium de l'alliage d'aluminium-silicium est comprise entre 25 et 90 %-poids, de préférence entre 40 et 80 %-poids, rapportée à la masse totale de l'alliage d'aluminium-silicium.

5. Miroir métallique (10), comprenant un substrat revêtu selon l'une des revendications précédentes, le polissage de la couche (3) polissable étant de qualité optique.

6. Miroir métallique (10) selon la revendication précédente, **caractérisé en ce qu'**au moins une couche de traitement (4) est disposée sur la surface de la couche (3) polie qui est éloignée du substrat (1).

7. Miroir métallique (10) selon la revendication précédente, **caractérisé en ce qu'**au moins une couche de traitement (4) est une couche métallique, en particulier sélectionnée dans le groupe composé d'or, d'aluminium, d'argent, de molybdène-silicium ou de mélanges de ceux-ci.

8. Miroir métallique selon l'une des revendications 6 ou 7, **caractérisé en ce qu'**au moins une couche de traitement est une couche diélectrique ou une couche métal-diélectrique.

9. Miroir métallique (10) selon l'une des revendications 6 à 8, **caractérisé en ce qu'**une autre couche, en particulier une couche de protection (5), est disposée sur la couche de traitement (4).

10. Miroir métallique (10) selon la revendication précédente, **caractérisé en ce que** les matériaux pour la couche de protection (5) sont sélectionnés dans le groupe des oxydes métalliques.

11. Procédé de fabrication de miroirs métalliques (10) selon l'une des revendications 5 à 10, dans lequel la couche intermédiaire (2), la couche (3) polie, la couche de traitement (4) et/ou la couche de protection (5) sont appliquées au moyen d'un dépôt chimique en phase vapeur, d'un dépôt de couche atomique, d'une évaporation par faisceau d'électrons et/ou de procédés de pulvérisation.

12. Procédé de fabrication de miroirs métalliques (10) selon la revendication précédente, **caractérisé en ce que** le gaz de pulvérisation est sélectionné dans le groupe composé d'argon, d'oxygène, de xénon et de mélanges de ceux-ci.

13. Utilisation du miroir métallique (10) selon l'une des revendications 5 à 10 et/ou fabriqué selon l'une des revendications 11 à 12 dans un télescope à miroir ou dans une source de rayonnement EUV en tant que miroir collecteur.
